# EUROPEAN PATENT APPLICATION

(11) **EP 3 675 151 A1**
(43) Date of publication of application: **01.07.2020**
(21) Application number: 18822251.7
(22) Date of filing: 31.05.2018
(51) Int. Cl.: H01L 21/336, H01L 29/786, H01L 27/12

(54) **THIN FILM TRANSISTOR AND MANUFACTURING METHOD THEREFOR, AND ELECTRONIC DEVICE**

(30) Priority: 22.08.2017 CN 201710725264
(71) Applicant: BOE TECHNOLOGY GROUP CO., LTD., Beijing 100015 (CN); Peking University, Beijing 100871 (CN)
(72) Inventor: MENG, Hu, Beijing 100176 (CN); LIANG, Xuelei, Beijing 100176 (CN); XIA, Jiye, Beijing 100176 (CN); HUANG, Qi, Beijing 100176 (CN)
(74) Representative: Gesthuysen, Michael
(86) International application number: PCT/CN2018/089210
(87) International publication number: WO 2019/037504

(57) **Abstract**

A thin film transistor, a manufacturing method thereof, and an electronic device are provided. The thin film transistor comprises a passivation layer disposed on the active layer, wherein a step of forming the passivation layer includes forming an insulating first metal oxide layer, the first metal oxide layer being capable of moving a Fermi level of the active layer to a side of a forbidden band to a valence band.

## Description

### RELATED APPLICATION

The present application claims the benefit of Chinese Patent Application No. 201710725264.7, filed on August 22, 2017, the entire disclosure of which is incorporated herein by reference.

### FIELD

The present disclosure relates to the field of semiconductor technologies, and particularly to a thin film transistor, a manufacturing method thereof, and an electronic device.

### BACKGROUND

In recent years, thin film transistors have received increasing attention due to their excellent electrical and mechanical performances. Device structure of a bottom gate type thin film transistor reduces the number of process steps during a process of preparation and prevents more pollution, which is a device structure suitable for mass production.

Since a channel region of an active layer of a bottom gate type thin film transistor is exposed to air, it is easily affected by water and oxygen in the air, which will cause a great hysteresis of the transistor. This suppresses its application in the display field. Passivation methods in the related art include: direct growth of an oxide on the active layer by atomic layer deposition, preparation of silicon nitride and silicon oxide using a plasma enhanced chemical vapor deposition method, spin coating and passivation of an organic material, and the like. These passivation methods will lead to problems such as occurrence of bipolarity in a device.

### SUMMARY

An embodiment of the present disclosure provides a manufacturing method of a thin film transistor, comprising:
providing a substrate;
forming an active layer on the substrate;
forming, on a surface of the active layer facing away from the substrate, a passivation layer covering at least a channel region of the active layer;
wherein said forming, on a surface of the active layer facing away from the substrate, a passivation layer covering at least a channel region of the active layer comprises:
   forming an insulating first metal oxide layer, the first metal oxide layer being capable of moving a Fermi level of the active layer toward a side of a forbidden band close to a valence band.

For the manufacturing method as described above, wherein said forming, on a surface of the active layer facing away from the substrate, a passivation layer covering at least a channel region of the active layer further comprises:
forming an insulating second metal oxide layer, the second metal oxide layer being capable of moving the Fermi level of the active layer toward a side of the forbidden band close to a conduction band, majority carrier of the active layer being a hole under the effect of both the first metal oxide and the second metal oxide layer.

For the manufacturing method as described above, wherein said forming an insulating first metal oxide layer comprises:
forming a first metal oxide layer on the surface of the active layer facing away from the substrate;
said forming an insulating second metal oxide layer comprises:
   forming a second metal oxide layer on a surface of the first metal oxide layer facing away from the active layer.

For the manufacturing method as described above, wherein the first metal oxide layer is an yttrium oxide layer and the second metal oxide layer is an aluminum oxide layer.

For the manufacturing method as described above, wherein said forming an insulating first metal oxide layer comprises:
forming a metallic yttrium thin film on the surface of the active layer facing away from the substrate;
performing an oxidation process on the substrate on which the metallic yttrium thin film is formed to form an yttrium oxide thin film;
performing a patterning process on the yttrium oxide thin film to form the yttrium oxide layer.

For the manufacturing method as described above, wherein performing an oxidation process on the substrate on which the metallic yttrium thin film is formed to form an yttrium oxide thin film includes: heating the substrate on which the metallic yttrium thin film is formed in a gas atmosphere containing oxygen, or oxidizing the metallic yttrium thin film using ozone under UV irradiation.

For the manufacturing method as described above, wherein said forming a metallic yttrium thin film on the surface of the active layer facing away from the substrate comprises: forming a metallic yttrium thin film on the surface of the active layer facing away from the substrate using an electron beam coating process.

For the manufacturing method as described above, wherein said forming an insulating second metal oxide layer comprises: forming an aluminum oxide thin film on a surface of the first metal oxide layer facing away from the active layer by atomic layer deposition, and performing a patterning process on the aluminum oxide thin film to form the aluminum oxide layer.

For the manufacturing method as described above, wherein the active layer is made of network carbon nanotubes.

For the manufacturing method as described above, wherein said forming an active layer on the substrate comprises:
dispersing carbon nanotubes in an organic solvent to form a first solution;
soaking the substrate in the first solution, after taking out the substrate, forming a first thin film on the substrate, the carbon nanotubes being randomly distributed in the first thin film to form network carbon nanotubes;
performing a patterning process on the first thin film to form a pattern of the active layer.

For the manufacturing method as described above, wherein the organic solvent is at least one of toluene, xylene, chloroform and o-xylene.

For the manufacturing method as described above, wherein after forming a first thin film on the substrate and before performing a patterning process on the first thin film to form a pattern of the active layer, said forming an active layer on the substrate further comprises:
washing the substrate with o-xylene and then drying it.

For the manufacturing method as described above, wherein said forming, on a surface of the active layer facing away from the substrate, a passivation layer covering at least a channel region of the active layer further comprises:
forming an inorganic insulating layer, the inorganic insulating layer being capable of moving the Fermi level of the active layer to a direction where the conduction band resides, majority carrier of the active layer being a hole under the effect of both the first metal oxide layer and the inorganic insulating layer.

For the manufacturing method as described above, wherein said forming an insulating first metal oxide layer comprises:
forming a first metal oxide layer on the surface of the active layer facing away from the substrate;
said forming an inorganic insulating layer comprises:
   forming an inorganic insulating layer on a surface of the first metal oxide layer facing away from the active layer.

For the manufacturing method as described above, wherein the inorganic insulating layer is made of one of silicon nitride and silicon oxide.

An embodiment of the present disclosure further provides a thin film transistor comprising: a substrate; an active layer on the substrate; and a passivation layer disposed on a surface of the active layer facing away from the substrate and covering at least a channel region of the active layer. The passivation layer includes an insulating first metal oxide layer, the first metal oxide layer being capable of moving a Fermi level of the active layer toward a side of a forbidden band close to a valence band.

For the thin film transistor as described above, wherein the passivation layer further includes a second metal oxide layer, the second metal oxide layer being capable of moving the Fermi level of the active layer toward a side of the forbidden band close to a conduction band, majority carrier of the active layer being a hole under the effect of both the first metal oxide layer and the second metal oxide layer.

For the thin film transistor as described above, wherein the first metal oxide layer is disposed on and in contact with the surface of the active layer facing away from the substrate;
the second metal oxide layer is disposed on and in contact with a surface of the first metal oxide layer facing away from the active layer.

For the thin film transistor as described above, wherein the first metal oxide layer is an yttrium oxide layer, and the second metal oxide layer is an aluminum oxide layer;
the yttrium oxide layer has a thickness ranging from 1 to 10 nm, and the aluminum oxide layer has a thickness ranging from 20 to 200 nm.

For the thin film transistor as described above, wherein the passivation layer further includes an inorganic insulating layer, the inorganic insulating layer being capable of moving the Fermi level of the active layer toward a side of the forbidden band close to a conduction band, majority carrier of the active layer being a hole under the effect of both the first metal oxide layer and the inorganic insulating layer.

For the thin film transistor as described above, wherein the first metal oxide layer is disposed on and in contact with the surface of the active layer facing away from the substrate;
the inorganic insulating layer is disposed on and in contact with a surface of the first metal oxide layer facing away from the active layer.

For the thin film transistor as described above, wherein a material of the active layer employs network carbon nanotubes.

An embodiment of the present disclosure further provides an electronic device using the thin film transistor as described above.

### BRIEF DESCRIPTION OF THE DRAWINGS

In order to more clearly illustrate embodiments of the present disclosure or technical solutions in the prior art, drawings that need to be used for description of the embodiments or the prior art will be briefly described below. Obviously, the drawings in the description below are merely some embodiments of the present disclosure, and other drawings may be further obtained by those ordinarily skilled in the art without spending inventive efforts.
Fig. 1 illustrates a flow chart of a method for forming a passivation layer in an embodiment of the present disclosure;
Fig. 2 illustrates another flow chart of a method for forming a passivation layer in an embodiment of the present disclosure;
Fig. 3 illustrates a transfer characteristic curve of a thin film transistor when an active layer of the thin film transistor is passivated using only an yttrium oxide layer in an embodiment of the present disclosure;
Fig. 4 illustrates a transfer characteristic curve of a thin film transistor when an active layer of the thin film transistor is passivated using only an aluminum oxide layer in an embodiment of the present disclosure;
Fig. 5 illustrates a transfer characteristic curve of a thin film transistor when an active layer of the thin film transistor is passivated using both an yttrium oxide layer and an aluminum oxide layer in an embodiment of the present disclosure;
Fig. 6 illustrates a schematic structural view of a thin film transistor in an embodiment of the present disclosure;
Fig. 7 illustrates a transfer characteristic curve of a thin film transistor when an active layer of the thin film transistor is not passivated.

### DETAILED DESCRIPTION

Implementations of the present disclosure will be further described in detail below with reference to the drawings and embodiments. The embodiments below are used for illustrating the present disclosure, but are not intended to limit the scope thereof.

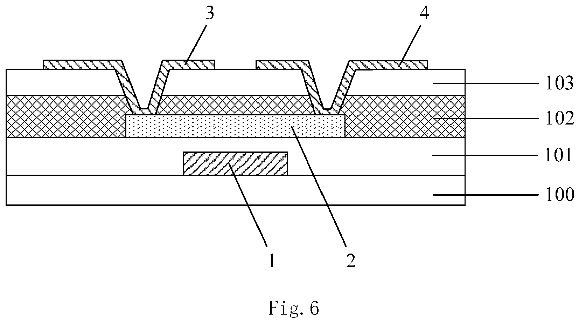

Referring to Fig. 6, this embodiment provides a manufacturing method of a thin film transistor, comprising:
providing a substrate 100;
forming an active layer 2, a source electrode 3 and a drain electrode 4 on the substrate 100, the active layer 2 including a source region in electrical contact with the source electrode 3, a drain region in electrical contact with the drain electrode 4, and a channel region between the source region and the drain region;
forming, on a surface of the active layer 2 facing away from the substrate 100, a passivation layer covering at least the channel region.

The step of forming the passivation layer includes:
forming an insulating first metal oxide layer 102, the first metal oxide layer 102 being capable of moving a Fermi level of the active layer 2 toward a side of a forbidden band close to a valence band.

In the above manufacturing method, the passivation layer for passivating the active layer of the thin film transistor includes the insulating first metal oxide layer 102. The first metal oxide layer is capable of moving the Fermi level of the active layer toward a side of the forbidden band close to the valence band, and thus has a hole-doping effect on the active layer, thereby overcoming the problem that the passivation technique in the related art will cause occurrence of bipolarity in the thin film transistor, and improving the performance of the product.

The first metal oxide layer 102 may be an yttrium oxide layer, a zirconium oxide layer or the like.

In the technical solution of the present disclosure, since the first metal oxide layer has a hole-doping effect on the active layer, a threshold voltage of the device will be increased, and the device cannot be easily turned off within a certain gate voltage range.

In order to solve the above technical problem, in a specific embodiment, the step of forming the passivation layer further includes:
forming an insulating second metal oxide layer 103, the second metal oxide layer 103 being capable of moving the Fermi level of the active layer 2 toward a side of the forbidden band close to a conduction band, majority carrier of the active layer 2 being a hole under the effect of both the first metal oxide layer 102 and the second metal oxide layer 103.

The second metal oxide layer formed by the above step is capable of moving the Fermi level of the active layer to a side of the forbidden band close to the conduction band, and thus has an electron-doping effect on the active layer, which can attenuate the hole-doping effect of the first metal oxide layer on the active layer to some extent, so that the device can be easily turned off. Moreover, majority carrier of the active layer is a hole under the effect of both the first metal oxide layer and the second metal oxide layer, which can prevent occurrence of bipolarity in the device.

The second metal oxide layer 103 may be, but not limited to, aluminum oxide, as long as it has the above functions.

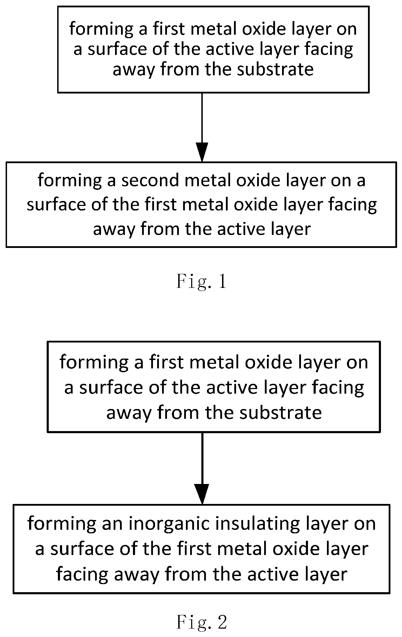

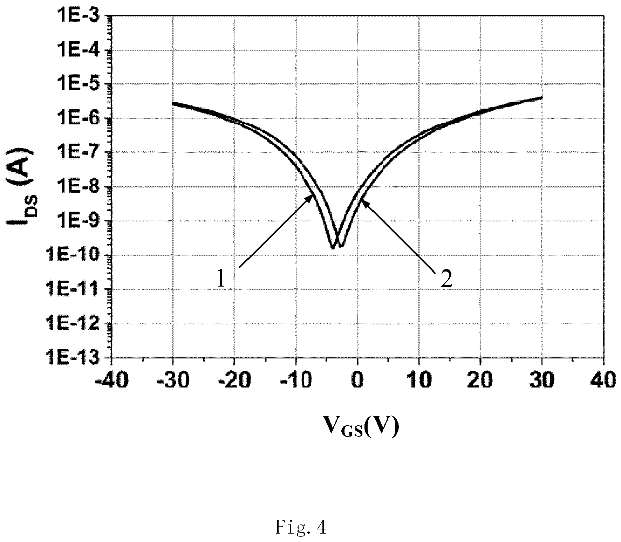

As shown in Fig. 1 and Fig. 4, when the passivation layer includes the first metal oxide layer 102 and the second metal oxide layer 103, optionally, the step of forming the passivation layer specifically is:
forming a first metal oxide layer 102 on the surface of the active layer 2 facing away from the substrate 100 to perform preliminary passivation on the active layer 2;
forming a second metal oxide layer 103 on a surface of the first metal oxide layer 102 facing away from the active layer 2 to perform secondary passivation on the active layer 2.

By means of the passivation layer prepared by the above steps, the first metal oxide layer is disposed in contact with the surface of the active layer to enhance the hole-doping effect on the active layer, which helps to achieve that majority carrier of the active layer is a hole, and prevents occurrence of bipolarity in the device. The secondary passivation performed by the second metal oxide layer can in turn attenuate the hole-doping effect of the first metal oxide layer on the active layer to some extent, so that the device can be easily turned off.

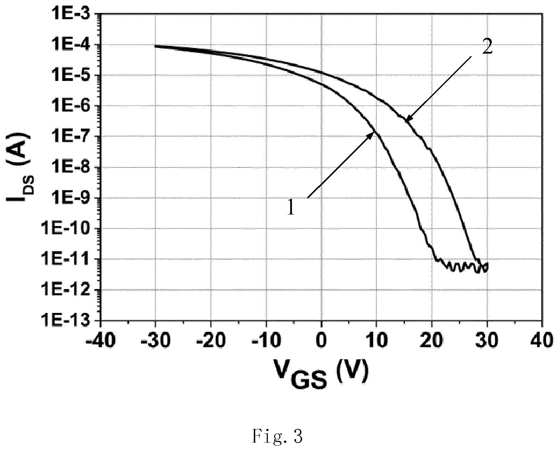

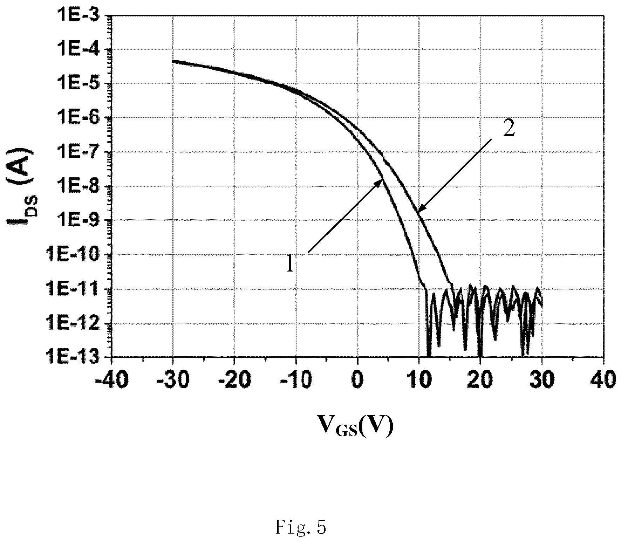

Based on an example in which the first metal oxide layer 102 is an yttrium oxide layer and the second metal oxide layer 103 is an aluminum oxide layer, when V_{DS}=-5.1V and only an yttrium oxide layer is formed on the active layer 2, a transfer characteristic curve of the device is as shown in Fig. 3. When only an aluminum oxide layer is formed on the active layer 2, a transfer characteristic curve of the device is as shown in Fig. 4. When an yttrium oxide layer and an aluminum oxide layer are formed successively on the surface of the active layer 2 facing away from the substrate 100, a transfer characteristic curve of the device is as shown in Fig. 5. By comparing Fig. 3, Fig. 4 and Fig. 5, it is apparent that after performing preliminary passivation on the active layer 2 using the yttrium oxide layer, performing secondary passivation on the active layer 2 using the aluminum oxide layer can effectively prevent occurrence of bipolarity in the device, and further ensure that the device can be easily turned off within a certain gate voltage range.

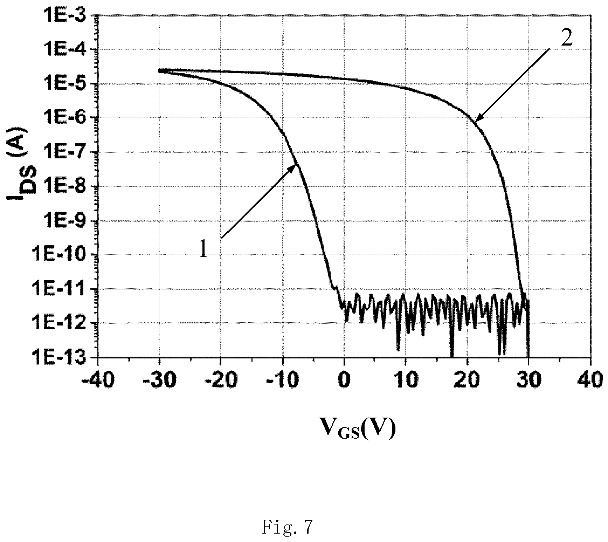

When the active layer is not passivated, that is, the active layer is exposed to air, a transfer characteristic curve of the thin film transistor is as shown in Fig. 7.

As can be seen from the drawings, the transfer characteristic curves of the device illustrated in Figs. 3 to 5 and 7 each include curve 1 and curve 2, wherein curve 1 represents a transfer characteristic curve of the device resulting from change of V_{GS} from a negative pressure to a positive pressure, and curve 2 represents a transfer characteristic curve of the device resulting from change of V_{GS} from a positive pressure to a negative pressure. Taking Fig. 4 as an example, curve 1 in Fig. 4 is a V-shaped curve on the left side, and curve 2 is a V-shaped curve on the right side. Curve 1 represents a transfer characteristic curve of the device resulting from change of V_{GS} from -30V to 30V, and curve 2 represents a transfer characteristic curve of the device resulting from change of V_{GS} from 30V to -30V.

In some embodiments, the step of forming an yttrium oxide layer specifically is:
forming a metallic yttrium thin film on the substrate;
performing an oxidation process on the substrate on which the metallic yttrium thin film is formed to form an yttrium oxide thin film;
performing a patterning process on the yttrium oxide thin film to form the yttrium oxide layer.

In the above steps, the yttrium oxide thin film is formed by first forming a metallic yttrium thin film and then performing an oxidation process on the metallic yttrium thin film. In order to obtain an yttrium oxide thin film with good quality and large thickness, the above steps may be repeated to prepare an yttrium oxide thin film having a desired thickness. Moreover, since the metallic yttrium thin film formed each time is thin, complete oxidation can be easily achieved, ensuring the quality of the prepared yttrium oxide thin film.

Specifically, the metallic yttrium thin film may be formed on the substrate 100 using a film formation process such as an electron beam coating process.

The metallic yttrium thin film formed each time may have a thickness ranging from 1 nm to 3 nm, and the finally prepared yttrium oxide thin film may have a thickness 20 nm to 30 nm.

The oxidation process performed on the metallic yttrium may specifically be: heating the substrate 100 on which the metallic yttrium thin film is formed in a gas atmosphere containing oxygen, and oxidizing the metallic yttrium thin film by oxygen in a high temperature environment to produce a metallic yttrium thin film. For example, the substrate 100 is heated to 250 °C in a gas atmosphere containing oxygen and oxidized for 30 min. Alternatively, the metallic yttrium thin film is oxidized by ozone under UV irradiation.

After the metallic yttrium thin film is prepared, an aluminum oxide thin film may be formed on a surface of the yttrium oxide layer facing away from the active layer 2 using a film formation process such as atomic layer deposition directly, and the aluminum oxide thin film is patterned to form the aluminum oxide layer. The aluminum oxide layer may have a thickness ranging from 20 nm to 200 nm.

In the above specific embodiment, the principle that the second metal layer has an electron-doping effect on the active layer is utilized to attenuate the hole-doping effect of the first metal oxide layer on the active layer to some extent, thereby ensuring that the device can be easily turned off while preventing occurrence of bipolarity in the device.

Of course, in order to overcome the problem that the first metal oxide layer has a strong hole-doping effect on the active layer, which causes that the device cannot be easily turned off, it is not limited to the above one solution.

In order to solve the above technical problem, in another specific embodiment, the step of forming the passivation layer further includes:
forming an inorganic insulating layer, the inorganic insulating layer being capable of moving the Fermi level of the active layer to a direction where the conduction band resides, majority carrier of the active layer being a hole under the effect of both the first metal oxide layer and the inorganic insulating layer.

The inorganic insulating layer formed by the above step is capable of moving the Fermi level of the active layer to a side of the forbidden band close to the conduction band, and thus has an electron-doping effect on the active layer, which can attenuate the hole-doping effect of the first metal oxide layer on the active layer to some extent, so that the device can be easily turned off. Moreover, majority carrier of the active layer is a hole under the effect of both the first metal oxide layer and the inorganic insulating layer, which can prevent occurrence of bipolarity in the device.

The inorganic insulating layer may be, but not limited to, silicon nitride or silicon oxide, as long as it has the above functions.

As shown in Fig. 2, when the passivation layer includes a first metal oxide layer and an inorganic insulating layer, optionally, the step of forming the passivation layer specifically includes:
forming a first metal oxide layer on the surface of the active layer facing away from the substrate to perform preliminary passivation on the active layer;
forming an inorganic insulating layer on a surface of the first metal oxide layer facing away from the active layer to perform secondary passivation on the active layer.

By means of the passivation layer prepared by the above steps, the first metal oxide layer is disposed in contact with the surface of the active layer to enhance the hole-doping effect on the active layer, which helps to achieve that majority carrier of the active layer is a hole and prevents occurrence of bipolarity in the device. The secondary passivation performed by the inorganic insulating layer can in turn attenuate the hole-doping effect of the first metal oxide layer on the active layer to some extent, so that the device can be easily turned off.

In this embodiment, the first metal oxide layer may be an yttrium oxide layer. The step of forming an yttrium oxide layer may refer to the above-described embodiment, and will not be described in detail herein.

In the above two embodiments, after performing preliminary passivation on the active layer using the first metal oxide layer, secondary passivation is further performed on the active layer so as to attenuate the hole-doping effect of the first metal oxide layer on the active layer to some extent, which ensures that the device can be easily turned off within a certain gate voltage range while preventing occurrence of bipolarity in the device, thereby improving the performance of the device.

Of course, the manner of performing secondary passivation on the active layer is not limited to the above two specific embodiments as long as the above purpose can be achieved.

In this embodiment, the active layer 2 is made of network carbon nanotubes. Since a network carbon nanotube thin film has advantages such as high mobility, high switching ratio, flexibility, transparency and the like, it is a promising channel material of the thin film transistor for display driving. A large-scale, uniform network carbon nanotube thin film can be prepared by printing, deposition, pulling and the like.

When the active layer is made of network carbon nanotubes, the step of forming the active layer specifically includes:
dispersing carbon nanotubes in an organic solvent to form a first solution;
soaking the substrate in the first solution, after taking out the substrate, forming a first thin film on the substrate, the carbon nanotubes in the first thin film being randomly distributed to form network carbon nanotubes;
patterning the first thin film to form a pattern of the active layer.

In the above steps, the substrate may be a Si/SiO₂ substrate. The substrate may be washed by an RCA cleaning process before being soaked in the first solution. The organic solvent may be selected from at least one of toluene, xylene, chloroform and o-xylene.

Optionally, after the step of forming a first thin film on the substrate, the manufacturing method further comprises:
washing the substrate with o-xylene and then drying it.

The patterning process performed on the first thin film includes coating and exposing a photoresist, forming a pattern of the photoresist after development, and etching the first thin film with the photoresist as a barrier to form a pattern of the active layer.

Based on an example in which the thin film transistor is a bottom gate type network carbon nanotube thin film transistor, in this embodiment, as shown in Fig. 6, the manufacturing method of a thin film transistor specifically comprises the following steps.

Step S1 A substrate 100, e.g. a glass substrate, a quartz substrate, a flexible substrate, is provided.

The substrate 100 may be washed by an RCA cleaning process.

Step S2 A gate metal thin film is formed on the substrate 100, and a patterning process is performed on the gate metal thin film to form a gate electrode 1 of the thin film transistor. The gate metal thin film may be metals such as Cu, Al, Ag, Mo, Cr, Nd, Ni, Mn, Ti, Ta and W as well as alloys of these metals. The gate metal thin film may have a single layer structure or a multilayer structure such as Cu\Mo, Ti\Cu\Ti, Mo\Al\Mo, and the like. The patterning process includes coating, exposing and developing a photoresist, etching and peeling off the photoresist, etc.

Step S3 A gate insulating layer 101 covering the gate electrode 1 is formed. A material of the gate insulating layer 101 may be selected from an oxide, a nitride or an oxynitride, and the gate insulating layer 101 may have a single layer structure, a double layer structure or a multilayer structure. Specifically, the material of the gate insulating layer 101 may be SiNx, SiOx or Si(ON)x.

Step S4 A pattern of the active layer 2 is formed on the gate insulating layer 101, wherein the active layer 2 is made of network carbon nanotubes.

It specifically includes:
dispersing carbon nanotubes in an organic solvent to form a first solution, wherein the organic solvent may be selected from at least one of toluene, xylene, chloroform and o-xylene;
soaking the substrate 100 where step S3 has been carried out in the first solution, and after a period of time, taking out the substrate 100 to form a first thin film on the gate insulating layer 101, the carbon nanotubes in the first thin film being randomly distributed to form network carbon nanotubes;
washing the substrate 100 with o-xylene and then drying it;
coating a photoresist on the first thin film, exposing the photoresist using a mask, and forming a photoresist-retained region and a photoresist-unretained region after development, the photoresist-retained region corresponding to a region where the active layer 2 resides, the photoresist-unretained region corresponding to other regions; removing the first thin film in the photoresist-unretained region; peeling off the remaining photoresist, and the first thin film in the photoresist-retained region forming the active layer 2.

Step S5 A metallic yttrium thin film is formed by an electron beam coating process on the substrate 100 where step S4 has been carried out, the metallic yttrium thin film having a thickness ranging from 1 nm to 3 nm, and performing an oxidation process on the metallic yttrium thin film to form an yttrium oxide thin film; repeating the above steps until the thickness of the yttrium oxide thin film is 20 nm to 30 nm;

Step S6 An aluminum oxide thin film is formed by an atomic layer deposition process on the substrate 100 where step S5 has been carried out, the aluminum oxide film having a thickness ranging from 20 nm to 200 nm.

Step S7 A patterning process is performed on the yttrium oxide thin film and the aluminum oxide thin film to form an yttrium oxide layer 102 and an aluminum oxide layer 103. The yttrium oxide layer 102 and the aluminum oxide layer 103 have via holes whose positions are corresponding to each other, that is, a via hole penetrating the yttrium oxide layer 102 and the aluminum oxide layer 103 is formed.

Step S8 A source-drain metal thin film is formed on the substrate 100 where step S7 has been carried out, and a patterning process is performed on the source-drain metal thin film to form a source electrode 3 and a drain electrode 4. The source electrode 3 and the drain electrode 4 are in electrical contact with the active layer 2 through the via hole penetrating the yttrium oxide layer 102 and the aluminum oxide layer 103.

The material of the source-drain metal thin film may be selected from metals such as Cu, Al, Ag, Mo, Cr, Nd, Ni, Mn, Ti, Ta and W, and alloys of these metals. The source-drain metal thin film may have a single layer structure or a multilayer structure such as Cu\Mo, Ti\Cu\Ti, Mo\Al\Mo, etc.

So far, fabrication of the thin film transistor is finished.

It is to be noted that the technical solution of the present disclosure is specifically introduced above only taking a bottom gate type thin film transistor as an example, and the technical solution of the present disclosure is also applicable to a top gate type thin film transistor and a coplanar type thin film transistor.

Referring to Fig. 6, this embodiment provides a thin film transistor, comprising:
a substrate 100;
an active layer 2, a source electrode 3 and a drain electrode 4 disposed on the substrate 100, the active layer 2 including a source region in electrical contact with the source electrode 3, a drain region in electrical contact with the drain electrode 4, and a channel region between the source region and the drain region;
a passivation layer disposed on a surface of the active layer 2 facing away from the substrate 100 and covering at least the channel region, the passivation layer including an insulating first metal oxide layer 102, the first metal oxide layer 102 being capable of moving the Fermi level of the active layer 2 toward a side of the forbidden band close to the valence band.

In the above thin film transistor, the passivation layer for passivating the active layer includes an insulating first metal oxide layer, and the first metal oxide layer is capable of moving the Fermi level of the active layer toward a side of the forbidden band close to the valence band, which has a hole-doping effect on the active layer, thereby overcoming the problem that the passivation technique in the related art causes occurrence of bipolarity in the thin film transistor, and improving the performance of the product.

The first metal oxide layer 102 may be yttrium oxide, zirconium oxide or the like.

Since the first metal oxide layer 102 has a hole-doping effect on the active layer 2, the threshold voltage of the device will be increased, and the device cannot be easily turned off within a certain gate voltage range.

In order to solve the above technical problem, in a specific embodiment, the passivation layer further includes a second metal oxide layer 103. The second metal oxide layer 103 is capable of moving the Fermi level of the active layer 2 to a direction in which the conduction band resides. Majority carrier of the active layer 2 is a hole under the effect of both the first metal oxide layer 102 and the second metal oxide layer 103.

The passivation layer of the above thin film transistor includes a first metal oxide layer and a second metal oxide layer. The second metal oxide layer is capable of moving the Fermi level of the active layer to a side of the forbidden band close to the conduction band, and thus has an electron-doping effect on the active layer, which can attenuate the hole-doping effect of the first metal oxide layer on the active layer, so that the device can be easily turned off. Moreover, majority carrier of the active layer is a hole under the effect of both the first metal oxide layer and the second metal oxide layer, which can prevent occurrence of bipolarity in the device.

Specifically, the first metal oxide layer 102 may be disposed on and in contact with the surface of the active layer 2 facing away from the substrate 100 to perform preliminary passivation on the active layer 2. The second metal oxide layer 103 is disposed on and in contact with the surface of the first metal oxide layer 102 facing away from the active layer 2 to perform secondary passivation on the active layer 2. In this technical solution, by disposing the first metal oxide layer 102 in contact with the surface of the active layer 2, the hole-doping effect on the active layer 2 can be enhanced, which helps to achieve that majority carrier of the active layer 2 is a hole, and prevents occurrence of bipolarity in the device. Moreover, the secondary passivation performed by the second metal oxide layer 103 can in turn attenuate the hole-doping effect of the first metal oxide layer 102 on the active layer 2 to some extent, so that the device can be easily turned off.

The first metal oxide layer 102 may be an yttrium oxide layer, and the second metal oxide layer 103 may be an aluminum oxide layer. The yttrium oxide layer has a thickness ranging from 1 nm to 10 nm, and the aluminum oxide layer has a thickness ranging from 20 nm to 200 nm.

In the above specific embodiment, the principle that the second metal layer has an electron-doping effect on the active layer is utilized so as to attenuate the hole-doping effect of the first metal oxide layer on the active layer to some extent, thereby ensuring that the device can be easily turned off while preventing occurrence of bipolarity in the device.

Of course, in order to overcome the problem that the first metal oxide layer 102 has a strong hole-doping effect on the active layer 2, which causes that the device cannot be easily turned off, it is not limited to the above one solution.

In order to solve the above technical problem, in another embodiment, the passivation layer further includes an inorganic insulating layer. The inorganic insulating layer is capable of moving the Fermi level of the active layer to a direction in which the conduction band resides, and majority carrier of the active layer is a hole under the effect of both the first metal oxide layer and the inorganic insulating layer.

The passivation layer of the above thin film transistor includes a first metal oxide layer and an inorganic insulating layer. The inorganic insulating layer is capable of moving the Fermi level of the active layer toward a side of the forbidden band close to the conduction band, and thus has an electron-doping effect on the active layer, which can attenuate the hole-doping effect of the first metal oxide layer on the active layer to some extent, so that the device can be easily turned off. Moreover, majority carrier of the active layer is a hole under the effect of both the first metal oxide layer and the inorganic insulating layer, which can prevent occurrence of bipolarity in the device.

Specifically, the first metal oxide layer may be disposed on and in contact with the surface of the active layer facing away from the substrate to perform preliminary passivation on the active layer. The inorganic insulating layer is disposed on and in contact with the surface of the first metal oxide layer facing away from the active layer to perform secondary passivation on the active layer. In this technical solution, by disposing the first metal oxide layer in contact with the surface of the active layer, the hole-doping effect on the active layer can be enhanced, which helps to achieve that majority carrier of the active layer is a hole, and prevents occurrence of bipolarity in the device. Moreover, the secondary passivation performed by the inorganic insulating layer can in turn attenuate the hole-doping effect of the first metal oxide layer on the active layer to some extent, so that the device can be easily turned off.

In this embodiment, the active layer 2 is made of network carbon nanotubes. Since a network carbon nanotube thin film has advantages such as high mobility, high switching ratio, flexibility, transparency and the like, it is a promising channel material of the thin film transistor for display driving. A large-scale, uniform network carbon nanotube thin film can be prepared by printing, deposition, pulling and the like.

Based on an example in which the thin film transistor is a bottom gate type network carbon nanotube thin film transistor, in this embodiment, as shown in Fig. 6, the thin film transistor specifically comprises:
a substrate 100, e.g. a glass substrate, a quartz substrate, a flexible substrate;
a gate electrode 1 disposed on the substrate 100;
a gate insulating layer 101 covering the gate electrode 1;
a pattern of an active layer 2 disposed on the gate insulating layer 101, the active layer 2 being made of network carbon nanotubes;
an yttrium oxide layer 102 and an aluminum oxide layer 103 covering the active layer 2 successively;
a source electrode 3 and a drain electrode 4 disposed on the aluminum oxide layer 103, the source electrode 3 and the drain electrode 4 being in electrical contact with the active layer 2 through a via hole penetrating the yttrium oxide layer 102 and the aluminum oxide layer 103.

In some embodiments of the present disclosure, an electronic device is further provided, which adopts the thin film transistor as described above. It can achieve passivation of the thin film transistor and further prevent occurrence of bipolarity in the transistor, thereby effectively improving the performance of the device.

The electronic device can significantly improve the quality of a display product when it is not limited to a display device.

What have been described above are merely optional embodiments of the present disclosure. It is to be noted that those ordinarily skilled in the art can further make improvements and substitutions without departing from the technical principle of the present disclosure. These improvements and substitutions are also considered to fall within the scope of the present disclosure.

## Claims

1. A manufacturing method of a thin film transistor, comprising:
providing a substrate;
forming an active layer on the substrate;
forming a passivation layer on a surface of the active layer facing away from the substrate, the passivation layer covering at least a channel region of the active layer;
wherein said forming a passivation layer comprises:
forming an insulating first metal oxide layer, the first metal oxide layer being capable of moving a Fermi level of the active layer toward a side of a forbidden band close to a valence band.

2. The manufacturing method according to claim 1, wherein said forming a passivation layer further comprises:
forming an insulating second metal oxide layer, the second metal oxide layer being capable of moving the Fermi level of the active layer toward a side of the forbidden band close to a conduction band, majority carrier of the active layer being a hole under the effect of both the first metal oxide and the second metal oxide layer.

3. The manufacturing method according to claim 2, wherein said forming an insulating first metal oxide layer comprises:
forming a first metal oxide layer on the surface of the active layer facing away from the substrate;
said forming an insulating second metal oxide layer comprises:
forming a second metal oxide layer on a surface of the first metal oxide layer facing away from the active layer.

4. The manufacturing method according to claim 2, wherein the first metal oxide layer is an yttrium oxide layer and the second metal oxide layer is an aluminum oxide layer.

5. The manufacturing method according to claim 4, wherein said forming an insulating first metal oxide layer comprises:
forming a metallic yttrium film on the surface of the active layer facing away from the substrate;
performing an oxidation process on the substrate on which the metallic yttrium film is formed to form an yttrium oxide film;
performing a patterning process on the yttrium oxide film to form the yttrium oxide layer.

6. The manufacturing method according to claim 5, wherein performing an oxidation process on the substrate on which the metallic yttrium film is formed to form an yttrium oxide film includes one of the followings:
heating the substrate on which the metallic yttrium film is formed in a gas atmosphere containing oxygen, and oxidizing the metallic yttrium film using ozone under UV irradiation.

7. The manufacturing method according to claim 5, wherein said forming a metallic yttrium film on the surface of the active layer facing away from the substrate comprises: forming a metallic yttrium film on the surface of the active layer facing away from the substrate using an electron beam coating process.

8. The manufacturing method according to claim 4, wherein said forming an insulating second metal oxide layer comprises: forming an aluminum oxide film on a surface of the first metal oxide layer facing away from the active layer by atomic layer deposition, and performing a patterning process on the aluminum oxide film to form the aluminum oxide layer.

9. The manufacturing method according to claim 1, wherein the active layer is made of network carbon nanotubes.

10. The manufacturing method according to claim 9, wherein said forming an active layer on the substrate comprises:
dispersing carbon nanotubes in an organic solvent to form a first solution;
soaking the substrate in the first solution, after taking out the substrate, forming a first film on the substrate, the carbon nanotubes being randomly distributed in the first film to form network carbon nanotubes;
performing a patterning process on the first film to form a pattern of the active layer.

11. The manufacturing method according to claim 10, wherein the organic solvent is at least one of toluene, xylene, chloroform and o-xylene.

12. The manufacturing method according to claim 10,wherein after forming a first film on the substrate and before performing a patterning process on the first film to form a pattern of the active layer, said forming an active layer on the substrate further comprises:
washing the substrate with o-xylene and then drying it.

13. The manufacturing method according to claim 1, wherein said forming a passivation layer further comprises:
forming an inorganic insulating layer, the inorganic insulating layer being capable of moving the Fermi level of the active layer to a direction where a conduction band resides, majority carrier of the active layer being a hole under the effect of both the first metal oxide layer and the inorganic insulating layer.

14. The manufacturing method according to claim 13, wherein said forming an insulating first metal oxide layer comprises:
forming a first metal oxide layer on the surface of the active layer facing away from the substrate;
said forming an inorganic insulating layer comprises:
forming an inorganic insulating layer on a surface of the first metal oxide layer facing away from the active layer.

15. The manufacturing method according to claim 13,wherein the inorganic insulating layer is made of one of silicon nitride and silicon oxide.

16. A thin film transistor comprising:
a substrate;
an active layer on the substrate; and
a passivation layer disposed on a surface of the active layer facing away from the substrate and covering at least a channel region of the active layer;
wherein the passivation layer includes an insulating first metal oxide layer, the first metal oxide layer being capable of moving a Fermi level of the active layer toward a side of a forbidden band close to a valence band.

17. The thin film transistor according to claim 16, wherein the passivation layer further includes a second metal oxide layer, the second metal oxide layer being capable of moving the Fermi level of the active layer toward a side of the forbidden band close to a conduction band, majority carrier of the active layer being a hole under the effect of both the first metal oxide layer and the second metal oxide layer.

18. The thin film transistor according to claim 17, wherein the first metal oxide layer is disposed on and in contact with the surface of the active layer facing away from the substrate;
the second metal oxide layer is disposed on and in contact with a surface of the first metal oxide layer facing away from the active layer.

19. The thin film transistor according to claim 18,wherein the first metal oxide layer is an yttrium oxide layer, and the second metal oxide layer is an aluminum oxide layer;
the yttrium oxide layer has a thickness ranging from 1 to 10 nm, and the aluminum oxide layer has a thickness ranging from 20 to 200 nm.

20. The thin film transistor according to claim 16, wherein the passivation layer further includes an inorganic insulating layer, the inorganic insulating layer being capable of moving the Fermi level of the active layer toward a side of the forbidden band close to a conduction band, majority carrier of the active layer being a hole under the effect of both the first metal oxide layer and the inorganic insulating layer.

21. The thin film transistor according to claim 20, wherein the first metal oxide layer is disposed on and in contact with the surface of the active layer facing away from the substrate;
the inorganic insulating layer is disposed on and in contact with a surface of the first metal oxide layer facing away from the active layer.

22. The thin film transistor according to claim 16, wherein a material of the active layer employs network carbon nanotubes.

23. An electronic device comprising the thin film transistor according to any one of claims 16 to 22.
